# EUROPÄISCHE PATENTSCHRIFT

(11) **EP 1 062 289 B1**
(45) Veröffentlichungstag und Bekanntmachung des Hinweises auf die Patenterteilung: **04.12.2002**
(21) Anmeldenummer: 00902553.7
(22) Anmeldetag: 11.01.2000
(51) Int. Cl.: C09J 9/02

(54) **LUMINESZIERENDER ELEKTRISCH LEITENDER KLEBSTOFF**
LUMINESCENT ELECTROCONDUCTIVE ADHESIVE
COLLE ELECTROCONDUCTRICE LUMINESCENTE

(30) Priorität: 14.01.1999 DE 19901107
(43) Veröffentlichungstag der Anmeldung: 27.12.2000
(73) Patentinhaber: ROBERT BOSCH GMBH, 70442 Stuttgart (DE)
(72) Erfinder: BRIELMANN, Volker, D-71332 Waiblingen (DE); FUESSL, Hans-Peter, D-72760 Reutlingen (DE)
(86) Internationale Anmeldenummer: DE0000069
(87) Internationale Veröffentlichungsnummer: WO00042114

(56) Entgegenhaltungen:
- EP-A- 0 680 411
- US-A- 4 999 136

## Beschreibung

### Stand der Technik

Die Erfindung betrifft einen lumineszierenden elektrisch leitenden Klebstoff nach der Gattung des Hauptanspruches.

Elektrisch leitende Klebstoffe sind bekannt und kommerziell erhältlich. Dazu sei beispielsweise auf das Produkt "Ablebond 84-1 LMI" der Firma Ablestik, 20021 Susanna Road, Rancho Domingues, CA 90221, USA verwiesen, bei dem es sich um einen silbergefüllten Klebstoff auf Epoxidharzbasis handelt.

Weiterhin sind bereits elektrisch nichtleitende Klebstoffe bekannt, denen zur Erzeugung einer Lumineszenz im sichtbaren Spektralbereich, beispielsweise durch Anregung im Ultravioletten mit Hilfe einer UV-Lampe, ein optischer Aufheller zugesetzt wird. Dazu sei beispielsweise auf bekannte Acrylatklebstoffe der Firma Loctite und der Firma Panacol verwiesen. Derartige nichtleitende Klebstoff werden überdies bereits großtechnisch in der Serienfertigung von elektrischen Schaltungsträgern eingesetzt, um die Verfahrensschritte einer an sich bekannten automatischen Detektion mittels Bilderkennungsgeräten und somit einer automatisierten Qualitäts- und Prozeßkontrolle zugänglich zu machen.

Bisher ist es jedoch kein elektrisch leitender Klebstoff mit einem insbesondere im sichtbaren Spektralbereich lumineszierenden Zusatzstoff bekannt, dessen Lumineszenz beispielsweise durch UV-Bestrahlung angeregt wird.

Derartige Ansätze scheiterten bislang daran, daß noch kein geeigneter Zusatzstoff gefunden wurde, da elektrisch leitende Klebstoffe in der Regel mit metallischen Partikeln, wie insbesondere Silber, gefüllt sind, die aufgrund ihrer Absorption vielfach eine detektierbare Lumineszenz verhindern.

Aufgabe der vorliegenden Erfindung ist es daher, einem an sich bekannten, elektrisch leitenden Klebstoff einen geeigneten, unter Lichteinfall lumineszierenden Zusatzstoff zuzugeben, so daß dieser Klebstoff beispielsweise in der Verklebung von elektrischen Bauelementen mit automatisierter Prozeßkontrolle eingesetzt werden kann.

### Vorteile der Erfindung

Der erfindungsgemäße Klebstoff mit den kennzeichnenden Merkmalen des Hauptanspruchs hat gegenüber dem Stand der Technik den Vorteil, daß damit beim Einsatz von elektrisch leitenden Klebstoffen, die sowohl isotrop als auch anisotrop elektrisch leitend sein können, und bei deren Anwendung auf organischen und anorganischen Schaltungsträgern in der Elektronik, auftretende Fehlerarten einfach und automatisiert detektiert werden können.

Derartige Fehlerarten können eine Verschmutzung des Schaltungsträgers oder eines aufgebrachten Bauelementes durch den Klebstoff, ein Ausbluten des Klebstoffes oder ein Ausschwemmen von Leitpartikeln aus dem Klebstoff sein. Diese Fehler treten häufig bei der Klebstoffapplikation, beispielsweise durch Sieb- oder Schablonendruck, beim Stempeln oder Dispensen oder beim Bestücken der Bauelemente, beispielsweise durch Klebstoffspritzer, auf. Aufgrund der fortschreitenden Miniaturisierung wird es immer schwieriger, diese Fehler mit herkömmlichen Methoden, beispielsweise durch Sichtkontrolle, zu erkennen.

Der erfindungsgemäße Klebstoff erlaubt hier sehr vorteilhaft eine automatisierte Kontrolle über an sich bekannte Bilderkennungsgeräte auch bei sehr kleinen Bauteilen oder Schaltungen und damit eine automatisierte Prozeß- und Qualitätskontrolle beim Klebstoffauftrag oder bei der Kontrolle gegebenenfalls verschmutzter Substratträger. Darüberhinaus ermöglicht er es, das Ausblut- und Ausschwemmverhalten des Leitklebstoffes auf dem Substrat bzw. dem Schaltungsträger zu analysieren. Insbesondere werden mit dem erfindungsgemäßen Klebstoff sehr vorteilhaft die ansonsten beim Einsatz von elektrisch leitenden Klebstoffen infolge von Leitklebertopographien auftretenden Reflexionen und Spiegelungen der Inspektionsbeleuchtung vermieden.

Vorteilhafte Weiterbildungen der Erfindung ergeben sich aus den in den Unteransprüchen genannten Maßnahmen.

So eignet sich als lumineszierender Zusatzstoff zu dem elektrisch leitenden Klebstoff besonders vorteilhaft ein Benzoxazol als heterocyclische Verbindung, die dem Klebstoff vorzugsweise mit einem Massenanteil von 0,01 % bis 0,5 %, insbesondere von 0,05 % zugesetzt ist.

Als elektrisch leitender Klebstoff wird vorteilhaft ein an sich bekannter, kommerziell erhältlicher silbergefüllter Epoxidharzklebstoff verwendet.

Weiterhin ist sehr vorteilhaft, daß die über Lumineszenz angeregte Helligkeit des Klebstoffes im sichtbaren Spektralbereich erfolgt und in einfacher Weise beispielsweise durch Bestrahlung mit einer UV-Lampe angeregt werden kann.

### Ausführungsbeispiele

Als elektrisch leitfähiger Klebstoff wird zunächst der Klebstoff Produkt "Ablebond 84-1 LMI" der Firma Ablestik, USA vorgegeben. Dabei handelt es sich um einen silbergefüllten Epoxidharzklebstoff. Diesem wird als heterocyclische Verbindung in an sich bekannter Weise ein Benzoxazol zugegeben und mit dem Klebstoff vermischt. Das Benzoxazol dient als optischer Aufheller in dem Klebstoff und zur Erzeugung einer Lumineszenz. Sein Massenanteil in dem Klebstoff zwischen 0,01 % bis 0,5 %, vorzugsweise bei 0,05%. Als besonders geeignet hat sich das Benzoxazol 2,2'-(2,5-Thiophenediyl)-bis(5-(1,1-dimethylethyl))-benzoazol oder 4-Phenyl-4'-Benzoxazolyl-stilbene herausgestellt.

Dieser lumineszierende elektrisch leitende Klebstoff wird dann in an sich bekannter Weise auf elektrische Schaltungsträger aufgebracht. Die Lumineszenz des Klebstoffes wird beispielsweise durch UV-Licht angeregt und über ein Lumineszenzmeßgerät oder eine optische Bilderkennung in an sich bekannter Weise innerhalb einer automatisierten Prozeßkontrolle detektiert.

## Patentansprüche

1. Elektrisch leitender Klebstoff, **dadurch gekennzeichnet, daß** dem elektrisch leitenden Klebstoff eine lumineszierende heterocyclische Verbindung zugesetzt ist.

2. Elektrisch leitender Klebstoff nach Anspruch 1, **dadurch gekennzeichnet, daß** die heterocyclische Verbindung ein Benzoxazol ist.

3. Elektrisch leitender Klebstoff nach Anspruch 1 oder 2, **dadurch gekennzeichnet, daß** der Massenanteil der heterocyclischen Verbindung in dem Klebstoff 0,01 % bis 0,5 %, insbesondere 0,05 % beträgt.

4. Elektrisch leitender Klebstoff nach Anspruch 1, **dadurch gekennzeichnet, daß** der Klebstoff ein silbergefüllter Epoxidharzklebstoff ist.

5. Elektrisch leitender Klebstoff, **dadurch gekennzeichnet, daß** die Lumineszenz, insbesondere bei Anregung im Ultravioletten, im sichtbaren Wellenlängenbereich auftritt.

6. Verwendung des elektrisch leitenden Klebstoffes nach mindestens einem der vorangehenden Ansprüche zum Verkleben von elektrischen Bauelementen auf Schaltungsträger mit automatisierter Prozeßkontrolle durch Bilderkennungsgeräte.

## Claims

1. Electrically conducting adhesive, **characterized in that** a luminescent heterocyclic compound has been added to the electrically conducting adhesive.

2. Electrically conducting adhesive according to Claim 1, **characterized in that** the heterocyclic compound is a benzoxazole.

3. Electrically conducting adhesive according to Claim 1 or 2, **characterized in that** the mass fraction of the heterocyclic compound in the adhesive is from 0.01% to 0.5%, especially 0.05%.

4. Electrically conducting adhesive according to Claim 1, **characterized in that** the adhesive is a silver-filled epoxy resin adhesive.

5. Electrically conducting adhesive, **characterized in that** the luminescence, especially in the case of excitation in the ultraviolet, occurs in the visible wavelength range.

6. Use of the electrically conducting adhesive according to at least one of the preceding claims for adhesively bonding electrical components to circuit carriers with automated process control by image recognition devices.

## Revendications

1. Colle électroconductrice
**caractérisée en ce qu'**
on ajoute une composition hétérocyclique luminescente à la colle électroconductrice.

2. Colle électroconductrice selon la revendication 1,
**caractérisée en ce que**
la combinaison hétérocyclique est un benzoxazol.

3. Colle électroconductrice selon l'une quelconque des revendication 1 ou 2,
**caractérisée en ce que**
la teneur massique de la combinaison hétérocyclique dans la colle représente entre 0,01 et 0,5 % et notamment 0,05 %.

4. Colle électroconductrice selon la revendication 1,
**caractérisée en ce que**
la colle est une colle de résine époxy chargée d'argent.

5. Colle électroconductrice,
**caractérisée en ce que**
la luminescence se produit notamment par excitation par une lumière ultraviolette, la luminescence se situant dans la plage des longueurs d'ondes visibles.

6. Application d'une colle électroconductrice selon au moins l'une quelconque des revendications précédentes pour coller des composants électriques sur des supports de circuits avec contrôle automatisé du procédé par des appareils de reconnaissance d'images.
